# EUROPEAN PATENT APPLICATION

(11) **EP 2 397 749 A2**
(43) Date of publication of application: **21.12.2011**
(21) Application number: 11170336.9
(22) Date of filing: 17.06.2011
(51) Int. Cl.: F21S 8/04, H05K 1/02, H01L 25/075, F21Y 101/02, F21Y 105/00, H05K 1/18, H01L 33/50

(54) **Light-emitting device and lighting apparatus**

(30) Priority: 21.06.2010 JP 2010141115; 24.06.2010 JP 2010144326
(71) Applicant: Toshiba Lighting & Technology Corporation, Yokosuka-shi Kanagawa 237-8510 (JP)
(72) Inventor: Betsuda, Nobuhiko, Kanagawa 237-8510 (JP); Shibusawa, Soichi, Kanagawa 237-8510 (JP); Matsuda, Shuhei, Kanagawa 237-8510 (JP); Nishimura, Kiyoshi, Kanagawa 237-8510 (JP); Kumagai, Masatoshi, Kanagawa 237-8510 (JP)
(74) Representative: Bokinge, Ole

(57) **Abstract**

According to one embodiment, a light-emitting device (1) includes a series circuit (K), a substrate (2), and a sealing member (4, 4Y). The series circuit (K) includes a plurality of parallel circuits (J) each including a plurality of light-emitting elements (3, 3a) connected in parallel. The plurality of parallel circuits (J) are connected in series. A plurality of groups are provided on the substrate (2). Each of the groups includes at least one of the light-emitting elements (3, 3a) in the parallel circuit (J). The light-emitting elements (3, 3a) are arranged in a divided manner according to each of the groups. The sealing member (4, 4Y) covers at least one of the light-emitting elements (3, 3a).

## Description

### FIELD

Embodiments described herein relate generally to a light-emitting device and a lighting apparatus which use a light-emitting element such as a light emitting diode (LED).

### BACKGROUND

Recently, a lighting apparatus in which a plurality of light-emitting elements such as LEDs are provided as a light source on a substrate to obtain a certain amount of light has been developed. Such a lighting apparatus is used, for example, as a so-called "direct-mounting type" which is base light that can be directly fitted to a surface of ceiling or the like. In this lighting apparatus, the plurality of LEDs are mounted on a substrate, for example, in a matrix shape.

The substrate comprises a parallel circuit including a plurality of series circuits each including a plurality of light-emitting elements connected in series to a power source.

### BRIEF DESCRIPTION OF THE DRAWINGS

FIG. 1 is a partially cutaway plan view of a light-emitting device according to a first embodiment;
FIG. 2 is a plan view of a wiring pattern of a substrate illustrated in FIG. 1;
FIG. 3 is an enlarged plan view of the substrate illustrated in FIG. 1 on which light-emitting elements are mounted;
FIG. 4 is a cross sectional view schematically illustrating the substrate illustrated in FIG. 1 and taken along a line F4 - F4;
FIG. 5 is a connecting diagram illustrating a connection state of the light-emitting elements illustrated in FIG. 1;
FIG. 6 is a perspective view of a lighting apparatus of a ceiling direct-mounting type provided with the light-emitting device according to the first embodiment;
FIG. 7 is a plan view of a light-emitting device according to a second embodiment;
FIG. 8 is a cross sectional view schematically illustrating a substrate illustrated in FIG. 7 and taken along a line F8 - F8;
FIG. 9 is a connecting diagram illustrating a connection state of light-emitting elements illustrated in FIG. 7;
FIG. 10 is a plan view of a light-emitting device according to a third embodiment;
FIG. 11 is a cross sectional view schematically illustrating a substrate illustrated in FIG. 10 and taken along a line F11 - F11;
FIG. 12 is a connecting diagram illustrating a connection state of light-emitting elements illustrated in FIG. 10;
FIG. 13 is a connecting diagram illustrating a connection state of light-emitting elements of a light-emitting device according to a fourth embodiment; and
FIG. 14 is a plan view illustrating a light-emitting device according to a fifth embodiment.

### DETAILED DESCRIPTION

In general, according to one embodiment, a light-emitting device includes a series circuit, a substrate, and a sealing member. The series circuit includes a plurality of parallel circuits each including a plurality of light-emitting elements connected in parallel. The plurality of parallel circuits are connected in series. A plurality of groups are provided on the substrate. Each of the groups includes at least one of the light-emitting elements in the parallel circuit. The light-emitting elements are arranged in a divided manner according to each of the groups. The sealing member covers at least one of the light-emitting elements.

In an embodiment, a lighting apparatus includes a apparatus body and the light-emitting device attached to the apparatus body.

Hereinafter, several embodiments will be described with reference to the drawings.

### (First Embodiment)

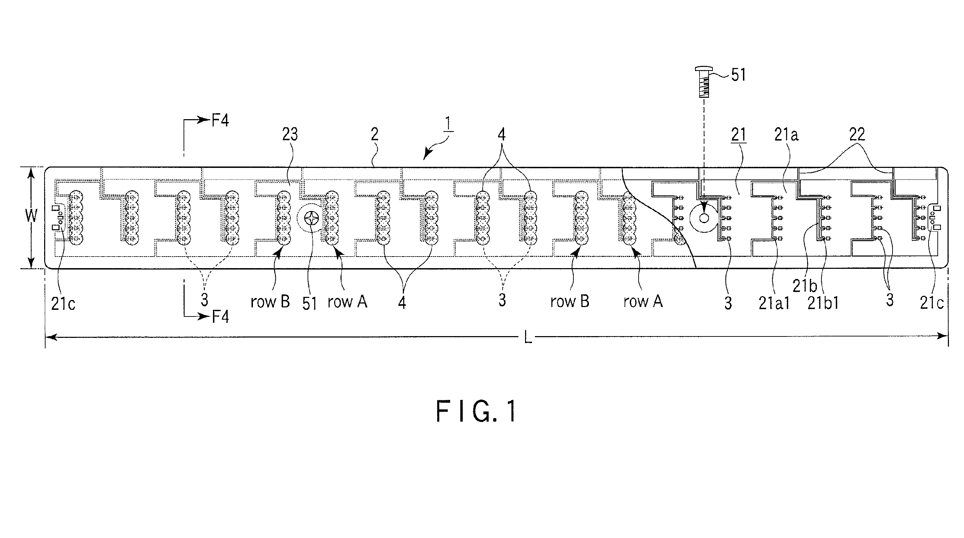

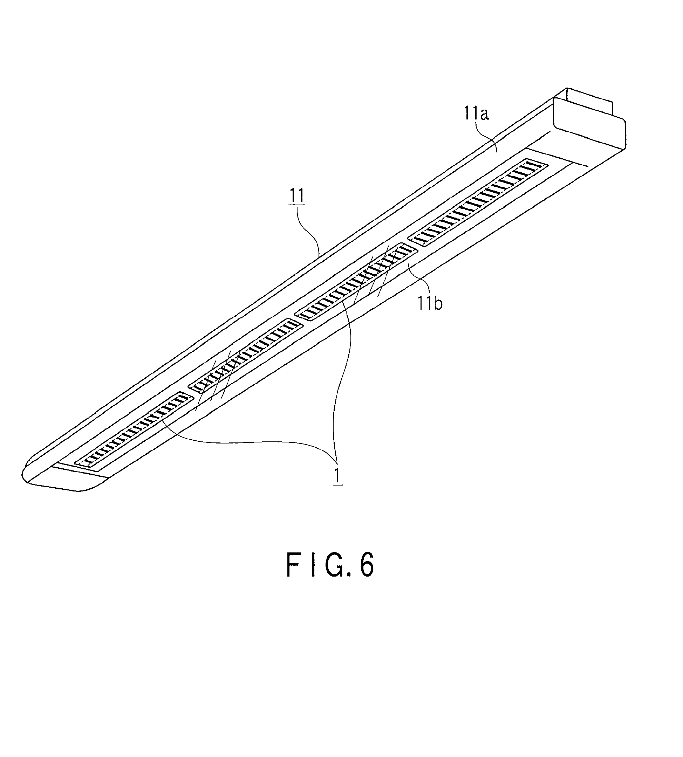

A first embodiment will be described with reference to FIGS. 1 to 6. FIGS. 1 to 5 illustrate a light-emitting device 1. FIG. 6 illustrates a lighting apparatus 11 including the light-emitting device 1. In each of the drawings, an identical portion is given an identical reference numeral, and a duplicated explanation thereof will be omitted.

As illustrated in FIG. 1, the light-emitting device 1 is provided with a substrate 2, a plurality of light-emitting elements 3, and a phosphor layer 4 covering each of the light-emitting elements 3 as a sealing member. FIG. 1 is a partially cutaway plan view of the light-emitting device 1 (the phosphor layer 4 and a resist layer 23 are removed on the right side of the illustration).

The substrate 2 is made of a material such as a glass epoxy resin and formed in substantially an elongated rectangular shape. A length L of the substrate 2 is 250 mm to 300 mm, and a width W thereof is 30 mm to 40 mm. In this embodiment, specifically, the length L is 280 mm, and the width W is 32 mm. The thickness of the substrate 2 is preferably 0.5 mm or more and 1.8 mm or less, and is 1 mm in this embodiment.

Both ends of the substrate 2, for example, in a longer direction may be rounded. In addition, it is also possible to use a ceramics material or other synthetic resin materials as a material for the substrate 2. Further, as the substrate, this embodiment does not preclude using a substrate with a metallic base plate to increase heat radiation of each of the light-emitting elements 3. Such a substrate is formed by laminating an insulating layer on a surface of a base plate such as aluminum having high thermal conductivity and good heat radiation performance.

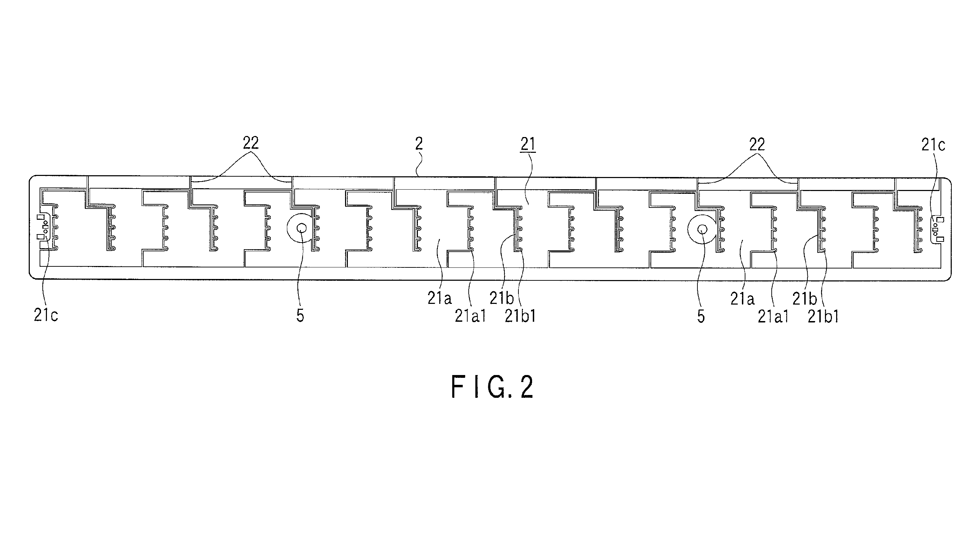

As illustrated in FIG. 2 as a representative illustration, a wiring pattern 21 and connection patterns 22 are formed on the substrate 2. The wiring pattern 21 is formed of mounting pads 21a, power conductors 21b, and power terminals 21c. The mounting pads 21a take a large proportion of an area on the substrate 2, and are arranged to take the plurality of light-emitting elements 3 mounted thereon. From the mounting pad 21a, the narrow and bended power conductor 21b continuously extends. The power conductor 21b extends in a direction perpendicular to the longer direction of the substrate 2.

The mounting pads 21a and the power conductors 21b are divided and formed in a plurality of blocks, specifically in 9 blocks, and are provided in the longer direction. Individual adjacent blocks are kept away from each other with an insulation distance to secure the insulating performance.

In addition, in each of the mounting pads 21a, power supply posts 21a1 are arranged in a direction perpendicular to the longer direction of the substrate 2. Similarly, the power conductor 21b is provided with power supply posts 21b1. Specifically, five convex power supply posts 21a1 and five convex power supply posts 21b1 are formed at regular intervals, respectively.

The power terminals 21c are connected to the mounting pads 21a or the power conductors 21b and provided on both sides of the substrate 2. A power connectors are connected to these power terminals 21c.

The connection patterns 22 have a narrow width, are connected to the mounting pads 21a, individually, and extend up to an end edge in a vertical direction of the substrate 2. The connection patterns 22 are used when the wiring pattern 21 is subjected to an electrolytic plating process. To be specific, the connection patterns 22 function as a connection path to make a portion of each of the mounting pads 21a equipotential when the wiring pattern 21 is subjected to the electrolytic plating. In this connection, a plating layer is also formed in portions of the connection patterns 22 simultaneously.

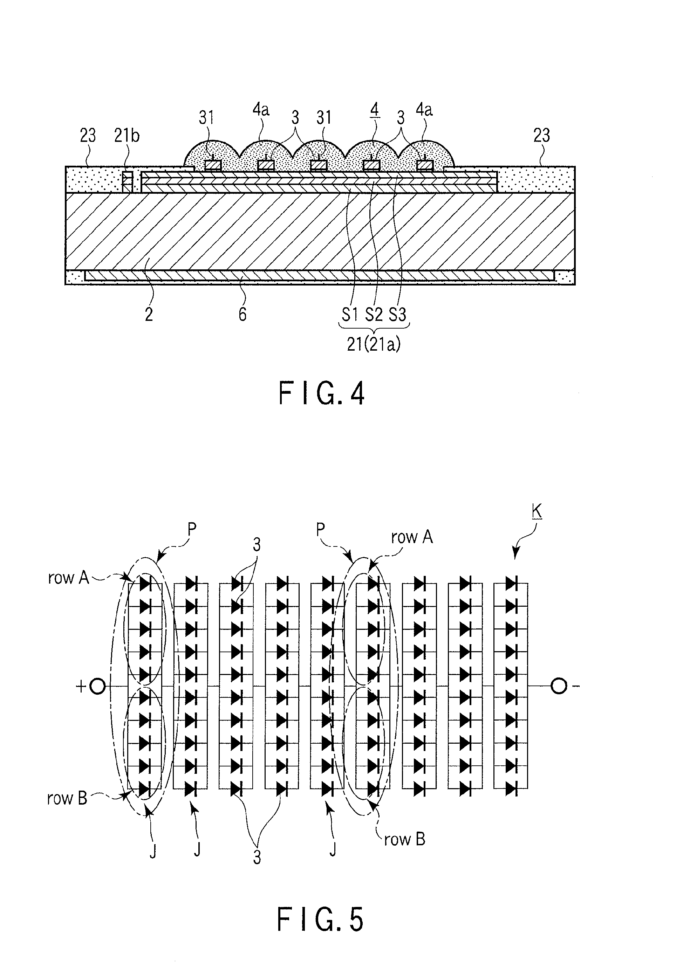

As illustrated in FIG. 4, the wiring pattern 21 and the connection patterns 22 have a three-layer structure including a first layer S1, a second layer S2, and a third layer S3. As the first layer S1, copper (Cu) is provided on a surface of the substrate 2. As the second layer S2, nickel (Ni) is processed by electrolytic plating. As the third layer S3, silver (Ag) having a high reflectance is processed by electrolytic plating. The third layer S3 of the mounting pads 21a, i.e., the surface layer, is formed of silver (Ag) by electrolytic plating and is formed as a reflecting layer whose whole ray reflectance is high as 90%.

In this electrolytic plating process, it is preferable that a thickness of nickel (Ni) of the second layer S2 be formed at 5 µm or more, and a thickness of silver (Ag) of the third layer S3 be at 1 µm or more. By arranging the thicknesses of the layers as described above, the layer thicknesses are formed uniformly, and thus a uniform reflectance can be obtained.

In addition, a white resist layer 23 having a high reflectance is laminated on almost an entire obverse side of the substrate 2 excluding mounting areas where the light-emitting elements 3 are mounted and mounting portions where components are mounted.

As illustrated in FIGS. 1, 3, and 4, each of the light-emitting elements 3 is formed of a bare LED chip. The bare LED chip that emits blue light is used so that a light-emitting portion is made to emit light of white color. The bare LED chip is bonded onto the mounting pad 21a using a silicon resin based insulating adhesive.

The bare LED chip is an element based on, for example, Indium-Gallium-Nitride series (InGaN) and has a structure in which a light-emitting layer is laminated on a translucent sapphire substrate. The light-emitting layer is formed by laminating sequentially an n-type nitride semiconductor layer, an InGaN light-emitting layer, and a p-type nitride semiconductor layer. Electrodes for supplying current to the light-emitting layer are formed of a positive electrode that is formed by a p-type electrode pad on the p-type nitride semiconductor layer, and a negative electrode that is formed by an n-type electrode pad on the n-type nitride semiconductor layer. These electrodes are electrically connected by bonding wires 31. Each of the bonding wires 31 is a thin wire made of gold (Au) and is connected through a bump formed of gold (Au) as a principal component to enhance a packaging strength and reduce damage to the bare LED chip.

The plurality of light-emitting elements 3 are arranged on the mounting pads 21a of the substrate 2 in a manner to form a plurality of rows (light-emitting elements row) in a direction perpendicular to the longer direction of the substrate 2. The plurality of light-emitting elements 3 are adhered onto the mounting pad 21a in a manner to individually correspond to the power supply posts 21a1 formed on the mounting pads 21a and the power supply posts 21b1 formed on the power conductors 21b.

Consequently, five light-emitting elements 3 are in a light-emitting elements row at substantially a regular intervals, and 18 light-emitting elements rows are formed in a direction perpendicular to the longer direction of the substrate 2 to thereby form an layout pattern of the light-emitting elements 3.

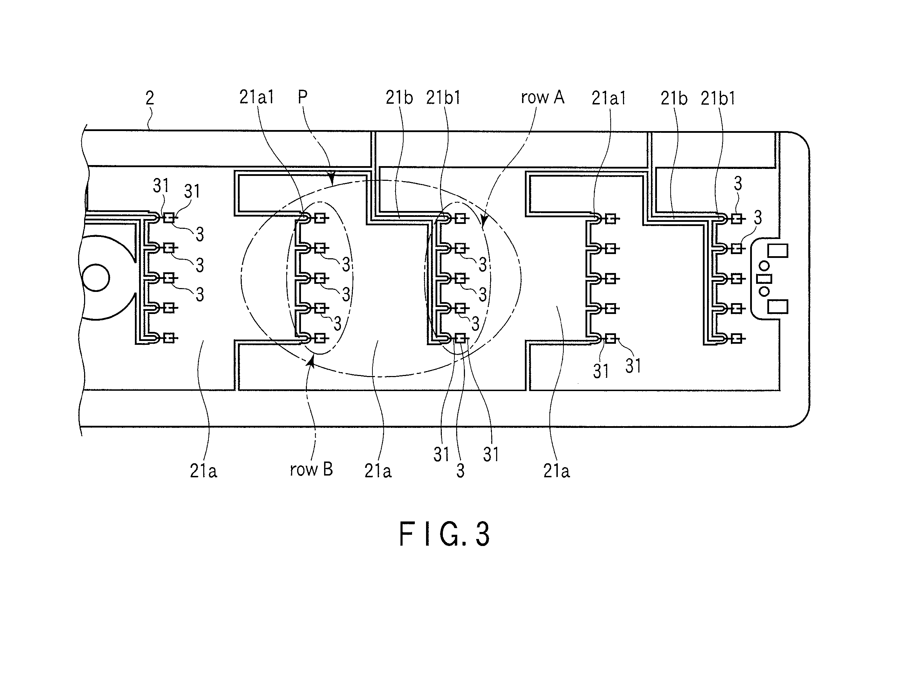

As illustrated in FIG. 3, for example, the plurality of light-emitting elements 3 arranged in a row A in the illustration are connected from a positive pole of the power source to a positive side electrode of the light-emitting element 3 through the power conductor 21b, the power supply post 21b1, and the bonding wire 31, and are connected from a negative side electrode of the light-emitting element 3 to the mounting pad 21a through the bonding wire 31.

Also, the plurality of light-emitting elements 3 arranged in a row B in the illustration, are connected from a positive pole of the power source to a positive side electrode of the light-emitting element 3 through the mounting pad 21a, the power supply posts 21a1, and the bonding wire 31, and are connected from a negative side electrode of the light-emitting element 3 to the mounting pad 21a through the bonding wire 31.

Accordingly, in the plurality of light-emitting elements 3 arranged in the row A and the plurality of light-emitting elements 3 arranged in the row B, the light-emitting electrodes 3 are electrically connected in parallel to the power source individually, and the two rows of the rows A and B of the light-emitting elements rows constitute a group P. These connections are repeated sequentially for nine groups of 18 rows in total so that power is supplied to each of the light-emitting elements 3.

The light-emitting elements 3 connected as described above form a connection state as illustrated in FIG. 5. To be specific, nine parallel circuits J each of which includes 10 light-emitting elements 3 connected in parallel form a series circuit K to be connected to the power source.

Among the plurality of light-emitting elements 3 in these parallel circuits J, an arbitrary number of elements (five in this embodiment) constitutes a group (for example, a group of the row A or a group of the row B) which then constitutes a plurality of groups. The light-emitting elements 3 are on the substrate 2 in a divided manner according to each of the groups. Each of the parallel circuits J includes the groups, for example. Each of the groups includes at least one of (or some of) the light-emitting elements 3.

Specifically, the plurality of light-emitting elements 3 in a single parallel circuit J are divided into two rows of light-emitting elements rows (row A and row B) each including five elements and provided on the substrate 2. As a layout pattern, 18 rows of the light-emitting elements rows are included.

Even if any one of the light-emitting elements 3 cannot emit light due to a poor connection or a broken wire of the bonding wire 31, the light-emitting device 1 as a whole does not stop emitting light.

Here, the number of light-emitting elements 3 in the parallel circuit J and the number of the parallel circuits J to be connected in series can be arbitrarily selected according to the design. Also, the number of divisions for dividing and laying the plurality of light-emitting elements 3 in a single parallel circuit J, i.e., the number of rows of the light-emitting elements rows, can be arbitrarily selected.

As illustrated in FIGS. 1 and 2, a pair of fitting holes 5 for fitting the substrate is provided between adjacent light-emitting elements rows in a center portion of the substrate 2. The fitting holes 5 are used for fitting the light-emitting device 1 to a body or the like of a lighting apparatus. Specifically, a fitting screw 51 serving as a fixing means penetrates through the fitting hole 5 and is screwed into the body or the like of the lighting apparatus so that the light-emitting device 1 is fitted.

Usually, these fitting holes 5 are provided in two end portions of the substrate 2, and therefore it is necessary to secure the space for the holes, which makes the substrate 2 larger by that amount. However, according to the arrangement described above, it is possible to form the fitting hole 5 between the light-emitting elements rows and make fitting by the fitting screw 51, which suppresses the size becoming larger. Also, in this case, if the fixing means is metallic, it is possible to provide an insulating distance. Moreover, since the fixing means does not fix the both end portions of the substrate 2 but fixes an inner side in the longer direction, i.e., the middle portion of the substrate 2, it is possible to effectively suppress the deformation of the substrate 2 such as warpage. Here, it is also possible to use an insulating material such as a synthetic resin as the fixing means.

As illustrated in FIGS. 1 and 4, the phosphor layer 4 is made of a translucent synthetic resin, e.g., a translucent silicone resin, and contains an appropriate amount of a phosphor such as YAG:Ce (Cerium doped Yttrium-Aluminum-Garnet). The phosphor layer 4 is formed of a group of a plurality of convex phosphor layers 4a that respectively cover each of the light-emitting elements 3. Each of the convex phosphor layers 4a is formed in a mound-like shape and a circular arc convex shape whose base is formed by being linked with the adjacent convex phosphor layers 4a. Therefore, the phosphor layer 4 is formed along the light-emitting elements rows in a plurality number of rows. To be specific, the phosphor layer 4 is formed in 18 rows and covers and seals each of the light-emitting elements 3 and the bonding wires 31.

The phosphor is excited by light emitted by the light-emitting element 3 and emits light of a color different from that of the light emitted by the light-emitting element 3. In this embodiment, since the light-emitting element 3 emits blue light, a yellow phosphor that emits yellow light which is a complementary color to the blue light is used so that white light can be emitted.

The phosphor layer 4 is applied, while it is not hardened, in a manner to correspond to each of the light-emitting elements 3 and each of the bonding wires 31 and is hardened thereafter through heat curing or leaving it intact for a predetermined period of time. To be specific, a translucent silicone resin material containing a phosphor whose viscosity and amount are adjusted, while it is not hardened, is supplied from a dispenser (not illustrated) by being dripped in a manner corresponding to each of the light-emitting elements 3 and each of the bonding wires 31.

In the foregoing arrangement, the description is given of the case in which each of the light-emitting elements 3 is covered by the convex phosphor layers 4a. However, two or three light-emitting elements 3 may be covered collectively together.

As illustrated in FIG. 4, the substrate 2 is provided with a pattern of copper foil 6 for heat radiation which is formed on an entire surface of a reverse side thereof. With this arrangement, the heat of the entire substrate 2 is made uniform, which improves the heat radiation performance. Here, a resist layer is laminated on the copper foil 6.

Next, referring to FIG. 6, a description will be given of the lighting apparatus 11 provided with the above-mentioned light-emitting device 1. The lighting apparatus 11 in the illustration is a ceiling direct-mounting type lighting apparatus having a size similar to an ordinary lighting apparatus of a 40 W fluorescent type fixed to the ceiling for use. The lighting apparatus 11 is provided with a body case 11a having an elongated and substantially rectangular parallelepiped shape. The body case 11a includes four of the light-emitting devices 1 that are connected linearly. This body case 11a is an example of the "apparatus body". A power supply unit provided with a power circuit is incorporated in the body case 11a. A front cover 11b having diffuseness is attached to a lower opening portion of the case 11a.

When power is supplied from the power circuit to the light-emitting device 1 arranged as described above, the light-emitting elements 3 are lit all together. Light emitted from the light-emitting element 3 passes through the phosphor layer 4 and is radiated. With this arrangement, the light-emitting device 1 is used as a surface light source emitting white light.

The mounting pad 21a functions as a heat spreader that diffuses heat generated by each of the light-emitting elements 3 while the light-emitting elements 3 emit light. When the light-emitting device 1 emits light, light traveling toward the substrate 2 among the light emitted from the light-emitting elements 3 is reflected by the surface layer of the mounting pad 21a mainly to a direction in which the light is utilized. This means that the light-extraction efficiency is made good. In addition, the light traveling in a side direction among the light emitted from the light-emitting elements 3 is reflected by a surface of the white resist layer 23 having a high reflectance and radiated toward a front side.

Here, for comparison, a light-emitting device structured by connecting, in parallel, a plurality of series circuits in which a plurality of LEDs are connected in series is taken. The light-emitting elements such as LEDs have individual differences. For this reason, in the lighting apparatus such as the one described above, the currents flowing through the individual series circuits in which a plurality of LEDs are connected in series may be different from one another. Consequently, light outputs or emitted colors of the plurality of LEDs of each of the series circuits may differ from one another, which causes a problem in which the uniformity of the illumination light drops as a whole.

According to the arrangement of this embodiment, it is possible to provide a light-emitting device and a lighting apparatus that can improve the uniformity of illumination light as a whole and broaden a degree of freedom of the layout pattern of the light-emitting elements.

This means that, since a parallel circuit J is provided with a plurality of light-emitting elements 3 that are connected in parallel, and a plurality of parallel circuits J are connected in series to provide a series circuit K, currents flowing through individual parallel circuits J (a group P in FIG. 3) become equal to each another, and thereby variations in light outputs or emitted colors of the individual parallel circuits J are reduced, and the uniformity of the illumination light as a whole can be improved.

Further, since a plurality of groups each having at least one of the light-emitting elements 3 in the parallel circuit J are formed, and the light-emitting elements 3 are on the substrate 2 in a divided manner for each group, it is possible to broaden a degree of freedom of the layout pattern of the light-emitting elements 3.

Furthermore, the plurality of light-emitting elements 3 are arranged in a direction perpendicular to the longer direction of the substrate 2 on the mounting pad 21a of the substrate 2 to form light-emitting elements rows. Therefore, it is possible to obtain a desired output by arbitrarily increasing or reducing the number of the light-emitting elements rows.

As described above, according to this embodiment, it is possible to provide a light-emitting device 1 and a lighting apparatus 11 that can improve the uniformity of illumination light as a whole and broaden a degree of freedom of the layout pattern of the light-emitting elements 3.

### (Second Embodiment)

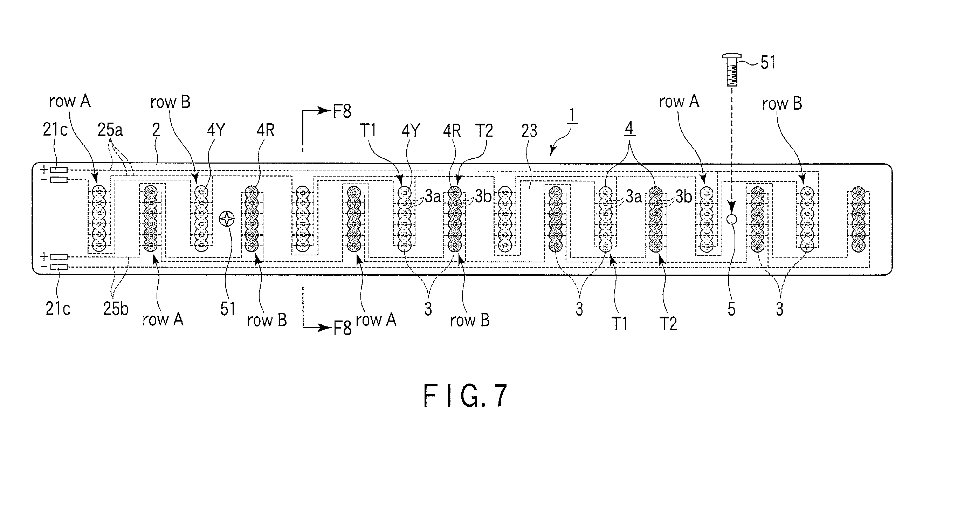

Next, a second embodiment will be described with reference to FIGS. 7 to 9. Here, a configuration having a function identical with or similar to that of the first embodiment is given the same reference numeral, and an explanation thereof will be omitted. In addition, configurations other than those described below are the same as those of the first embodiment.

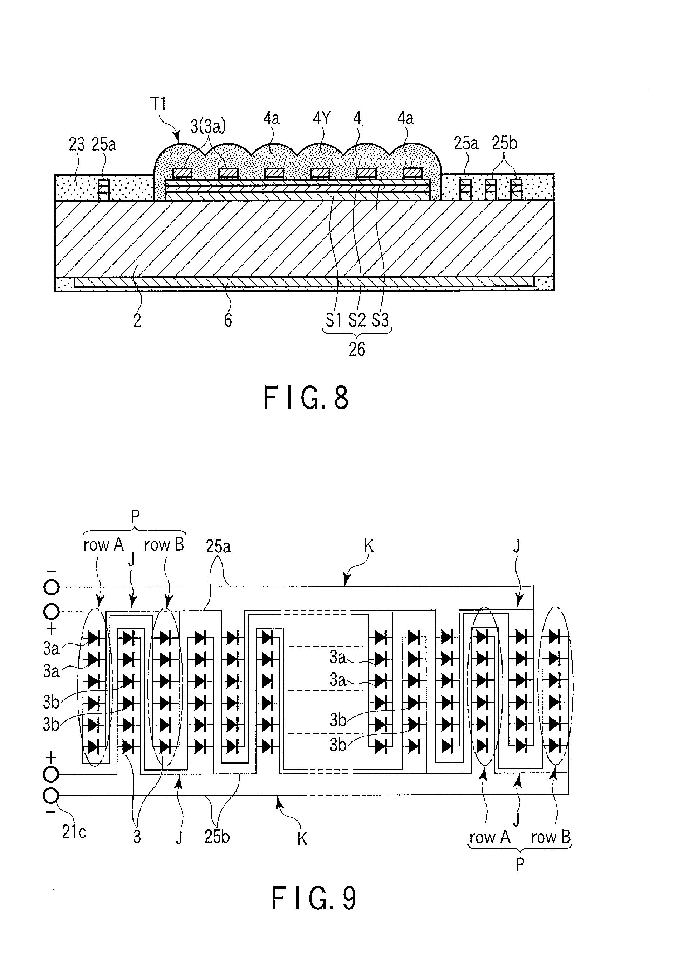

As illustrated in FIGS. 7 and 8, a first power feed line 25a, a second power feed line 25b, and mounting pads 26 are formed on a substrate 2. The first power feed line 25a and the second power feed line 25b are in the form of a wiring pattern and form electric power feed lines independently.

A positive pole line of the first power feed line 25a is formed linearly in an edge portion in the longer direction of the substrate 2 (upper side in the illustration), and a negative pole line is formed in a comb-like pattern having a plurality of projecting teeth. On the other hand, the positive pole line of the second power feed line 25b is formed linearly in an edge portion in the longer direction of the substrate 2 in a similar manner (lower side in the illustration), and a negative pole line is formed in a comb-like pattern having a plurality of projecting teeth that are individually arranged in gaps between adjacent teeth of the first power feed line 25a.

To be specific, the projecting teeth of the first power feed line 25a and the projecting teeth of the second power feed line 25b are arranged to be in gaps of each other formed between adjacent teeth of the both lines.

Power terminals 21c are individually connected to the first power feed lines 25a and the second power feed lines 25b. The power terminals 21c are provided at one end portion of the substrate 2 and formed in a manner to be connected to power connectors.

The plurality of light-emitting elements 3 are arranged on the mounting pads 26 of the substrate 2 in a direction perpendicular to the longer direction of the substrate 2 to form a plurality of rows. The light-emitting elements 3 includes light-emitting elements 3a (first light-emitting element) connected to the first power feed line 25a and light-emitting elements 3b (second light-emitting element) connected to the second power feed line 25b.

To be specific, six light-emitting elements 3a are at substantially regular intervals between the positive pole line and the negative pole line of the first power feed line 25a. Also, six light-emitting elements 3b are at substantially regular intervals between the positive pole line and the negative pole line of the second power feed line 25b.

This means that a plurality of rows of the light-emitting elements 3a (8 rows) connected to the first power feed line 25a and a plurality of rows of the light-emitting elements 3b (8 rows) connected to the second power feed line 25b are arranged alternately in the longer direction of the substrate 2, and, thus, a total of 16 rows of the light-emitting elements rows are formed in a distributed manner.

In each of the light-emitting elements rows, the light-emitting elements 3 positioned in the same light-emitting elements row are connected in parallel to the first power feed line 25a or the second power feed line 25b by the bonding wires 31. With this arrangement, the plurality of light-emitting elements 3 forming each of the light-emitting elements rows are electrically connected to one another in parallel.

Furthermore, as illustrated in FIG. 7, the plurality of light-emitting elements 3a arranged in a row A and the plurality of light-emitting elements 3a arranged in a row B are individually connected in parallel to each another electrically with respect to the first power feed line 25a. This means that two rows formed of rows A and B of the light-emitting element rows constitute a group P in terms of connection. Further, the plurality of light-emitting elements 3b arranged in the row A and the plurality of light-emitting elements 3b arranged in the row B are individually connected in parallel to each another electrically with respect to the second power feed ling 25b. This means that two rows formed of the rows A and B of the light-emitting element rows constitute a group P in terms of connection.

The light-emitting elements 3 connected in a manner as described above are in a connection state as illustrated in FIG. 9. FIG. 9 reflects an actual layout state of the first power feed line 25a, the second power feed line 25b, and the individual light-emitting elements 3 on the substrate 2.

To be specific, as to the first power feed line 25a, four of the parallel circuits J each having 12 light-emitting elements 3a connected in parallel are connected in series to form a series circuit K. Then, among the plurality of light-emitting elements 3a in the parallel circuit J, a plurality of groups each having an arbitrary number of the light-emitting elements 3a (6 in this embodiment) as a group (for example, a group of row A and a group of row B) are formed, and the light-emitting elements 3a are arranged in a divided manner according to each of the groups.

As to the second power feed line 25b, four of the parallel circuits J each having 12 light-emitting elements 3b connected in parallel are connected in series to form a series circuit K. Then, among the plurality of light-emitting elements 3b in the parallel circuit J, a plurality of groups each having an arbitrary number of the light-emitting elements 3b (6 in this embodiment) as a group (for example, a group of row A and a group of row B) are formed, and the light-emitting elements 3b are arranged in a divided manner according to each of the groups.

With this connection, even if any one of the light-emitting elements 3 cannot emit light due to a poor connection or a broken wire of the bonding wire 31, the light-emitting device 1 as a whole does not stop emitting light.

Here, the number of the light-emitting elements 3 in the parallel circuit J and the number of parallel circuits J that are connected in series can be arbitrarily selected according to the design. Also, the number of division for dividing the plurality of light-emitting elements 3 in a single parallel circuit J, i.e., the number of rows of the light-emitting elements rows, can be arbitrarily selected.

The first power feed line 25a and the second power feed line 25b form independent electric power feed lines, and therefore the first power feed line 25a and the second power feed line 25b can be selectively switched therebetween by a change-over switch etc. (not illustrated) provided on a power circuit.

As illustrated in FIGS. 7 and 8, the phosphor layer 4 is made of a translucent synthetic resin, e.g., a translucent silicone resin. In this embodiment, the phosphor layer 4 includes two types of layers of a first phosphor layer 4Y including a yellow phosphor as a phosphor and a second phosphor layer 4R including a yellow phosphor into which a red phosphor is mixed at a predetermined mixing ratio. The first phosphor layer 4Y is an example of a "first sealing member". The second phosphor layer 4R is an example of a "second sealing member".

The first phosphor layer 4Y covers the plurality of light-emitting elements 3a connected to the first power feed line 25a. The second phosphor layer 4R covers the plurality of light-emitting elements 3b connected to the second power feed line 25b. As a result, the plurality of light-emitting elements 3a connected to the first feed line 25a and the phosphor layer 4Y constitute a first light source T1. The plurality of light-emitting elements 3b connected to the second feed line 25b and the phosphor layer 4R constitute a second light source T2. In this way, the first light sources T1 and the second light sources T2 form the plurality of rows arranged in the longer direction of the substrate 2 and are disposed alternately in a distributed manner.

When the first power feed line 25a of the light-emitting device 1 having the above-mentioned configuration is selected and energized by the change-over switch etc. on the side of the power circuit, the first light sources T1 connected to the first power feed line 25a, that is, individual light-emitting elements 3a connected to the first power feed line 25a, are lit all together. The light emitted from the light-emitting element 3a passes through the phosphor layer 4Y and radiated. In this case, the blue light emitted from the light-emitting element 3a excites the yellow phosphor, is converted into yellow fluorescence by the yellow phosphor, and passes through the phosphor layer 4Y to be radiated outside. In addition, the light that does not excite the yellow phosphor among the blue light emitted from the light-emitting element 3a passes through the phosphor layer 4Y, as is, and is radiated outside. During this process, the yellow light and the blue light are combined together to become a daylight color having a correlated color temperature of 7000 K to 5000 K and emitted. To be specific, the correlated color temperature is set at 6700 K.

When the second power feed line 25b is selected and energized by the change-over switch etc. on the side of the power circuit, the second light sources T2 connected to the second power feed line 25b, that is, individual light-emitting elements 3b connected to the second power feed line 25b, are lit all together. The light emitted from the light-emitting element 3b passes through the phosphor layer 4R and radiated. In this case, the blue light emitted from the light-emitting element 3b excites the yellow phosphor and at the same time excites the red phosphor. With this arrangement, red fluorescence is emitted, the light that passes through the phosphor layer 4R to be radiated outside becomes light of light bulb color having a correlated color temperature of 3500 K to 2500 K because a red color component is added, and this light is emitted. To be specific, the correlated color temperature is set at 2700 K.

Here, both of the first power feed line 25a and the second power feed line 25b may be energized by the change-over switch etc. on the side of the power circuit. In this case, all of the light-emitting elements 3 emit light, and both of the first light sources T1 and the second light sources T2 are lit. Therefore, the correlated color temperature becomes the middle of the two.

The lighting apparatus 11 is provided with a body case 11a having an elongated and substantially rectangular parallelepiped shape, and four of the light-emitting devices 1 are connected linearly and attached to the body case 11a.

In a lighting apparatus of these days, a lot of bare LED chips are mounted on a substrate, and the individual LED chips are electrically connected by bonding wires and sealed with a sealing member containing phosphor. From this arrangement, light in daylight color, white, light bulb color, or the like is obtained.

However, there may be cases in which a desired light-emitting color is demanded according to a luminous environment or preference. In such cases, a method is conceived to obtain a desired luminance color by laying a plurality of LEDs having different emitting colors such as red, green, or blue on a substrate and mixing colors by adjusting the emission intensities or the like of the individual LEDs.

However, in such cases as describe above, it is difficult to obtain a desired luminance color because the configuration becomes complicated, and a plurality of luminance colors are mixed.

This embodiment is made in view of the foregoing subject, and makes it possible to provide a light-emitting device and a lighting apparatus that, with a simple configuration, can change the luminance color and improve the uniformity of illumination light as a whole.

In such the light-emitting device 1, it is possible to select a luminance color from among daylight color, white, and light bulb color by means of the first light sources T1 and the second light sources T2. In addition, since the first light sources T1 and the second light sources T2 are arranged in a distributed manner, it is possible to use it as a surface light source that is good in the uniformity in each light emitting color as a whole.

Additionally, since the number of light-emitting elements 3 and the number of the light-emitting elements rows are same between the first light source T1 and the second light source T2, even if any one of them is selected by switching, the distribution of light does not vary to a larger extent.

Further, since the plurality of light-emitting elements 3 form the light-emitting elements rows by being arranged on the mounting pad 26 of the substrate 2 in a plurality of quantities in a direction perpendicular to the longer direction of the substrate 2, it is possible to obtain a desired output by arbitrarily increasing or decreasing the number of light-emitting elements rows.

The mounting pad 26 functions as a heat spreader that diffuses heat generated by each of the light-emitting elements 3 while the light-emitting elements 3 emit light. When the light-emitting device 1 emits light, light traveling toward the substrate 2 among the light emitted from the light-emitting element 3 is reflected by the surface layer of the mounting pad 26 mainly to a direction in which the light is utilized. This means that the light-extraction efficiency can be made good. In addition, the light traveling in a side direction among the light emitted from the light-emitting elements 3 is reflected by a surface of the white resist layer 23 having a high reflectance and radiated toward a front side.

As described above, according to this embodiment, it is possible to provide a light-emitting device 1 and a lighting apparatus 11 that can change the luminance color and is good in the uniformity of illumination light as a whole.

Hereinafter, some embodiments related to the second embodiment will be described.

Second to fifth embodiments can provide a light-emitting device and a lighting apparatus that, with a simple configuration, can change the luminance color and improve the uniformity of illumination light as a whole.

The followings are those light-emitting devices and lighting apparatus.
(a) A light-emitting device according to an embodiment includes: a substrate; a first power feed line and a second power feed line formed on the substrate; first light sources each including a plurality of first light-emitting elements connected to the first power feed line and mounted on the substrate and a first sealing member to cover at least one of the first light-emitting elements, and configured to emit light having a predetermined correlated color temperature; second light sources each including a plurality of second light-emitting elements connected to the second power feed line and mounted on the substrate and a second sealing member to cover at least one of the second light-emitting elements, and configured to emit light having a correlated color temperature different from the correlated color temperature of the first light source, and the first light sources and the second light sources are on the substrate in a distributed manner.
(b) In the light-emitting device according to the foregoing (a), the correlated color temperature of the first light source is set at 7000 K to 4500 K, and the correlated color temperature of the second light source is set at 3500 K to 2500 K. That is, the correlated color temperature of the first light source is set at a (any) value between 7000 K and 4500 K. The correlated color temperature of the second light source is set at a (any) value between 3500 K and 2500 K.
(c) In the light-emitting device according to the foregoing (a) or (b), the first light sources and the second light sources are provided in a manner to form a plurality of rows arranged in a longer direction of the substrate.
(d) A lighting apparatus according to an embodiment includes: an apparatus body; and any one of the light-emitting devices described in the foregoing (a), (b), and (c) and attached to the apparatus body.

### (Third Embodiment)

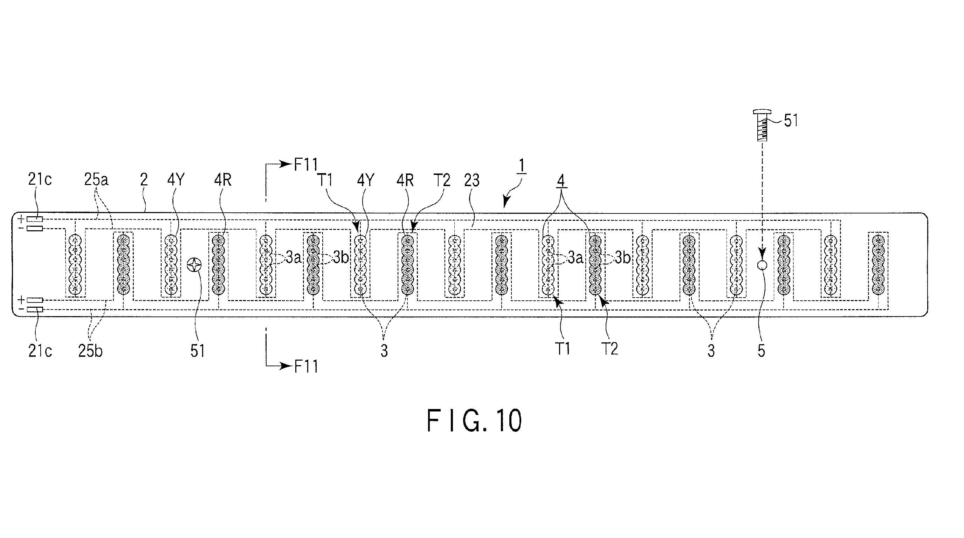

Next, a third embodiment will be described with reference to FIGS. 10 to 12. Here, a configuration having a function identical with or similar to those of the first and second embodiments is given the same reference numeral, and an explanation thereof will be omitted. In addition, configurations other than those described below are the same as those of the second embodiment.

In this embodiment, in each of light-emitting elements rows, different poles of light emitting elements 3 provided adjacent to one another in a direction in which the row extends are sequentially connected by bonding wires 31. That is, a positive pole of one of the adjacent light emitting elements 3 and a negative pole of the other of the adjacent light emitting elements 3 are connected to each other by the bonding wire 31, and this is sequentially repeated. With this arrangement, the plurality of light-emitting elements 3 constituting individual light-emitting elements rows are electrically connected to one another in series. Accordingly, the plurality of light-emitting elements 3 emit light all together when energized.

Further, in each of the light-emitting elements rows, an electrode of one light-emitting element 3 at an end of the row is connected to a first power feed line 25a or a second power feed line 25b by the bonding wire 31.

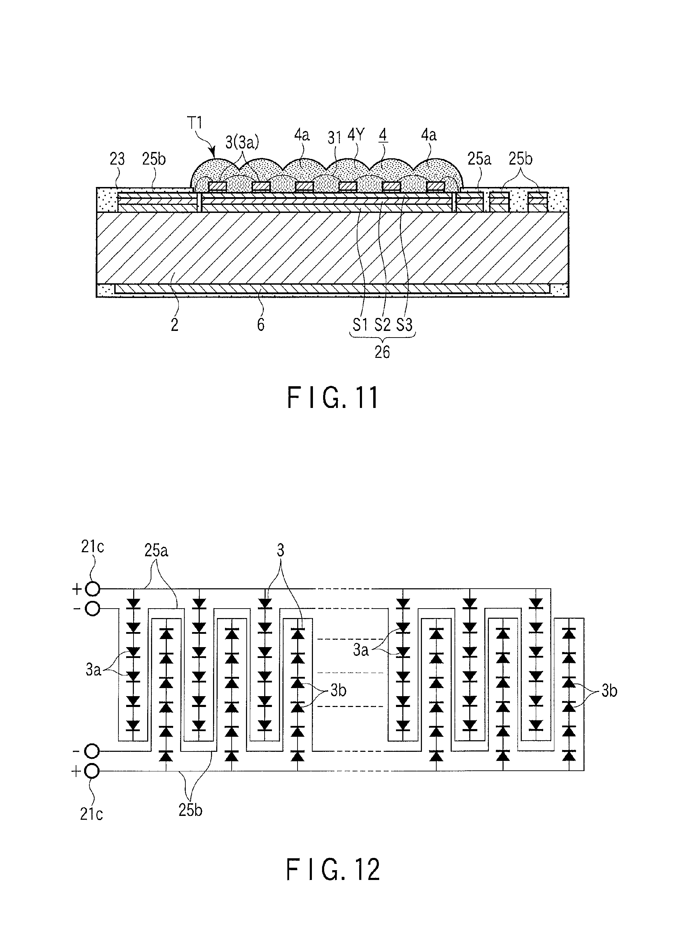

The connection state of the light-emitting elements 3 connected as described above is as illustrated in FIG. 12. FIG. 12 reflects an actual layout state of the first power feed line 25a, the second power feed line 25b, and the individual light-emitting elements 3 on the substrate 2.

A plurality of rows (9 rows) of the light-emitting elements 3a connected to the first power feed line 25a and a plurality of rows (9 rows) of the light-emitting elements 3b connected to the second power feed line 25b are alternately on the substrate 2 in the longer direction thereof. Accordingly, a total of 18 rows of light-emitting elements rows are provided in a distributed manner.

Nine series circuits each having six light-emitting elements 3a connected in series are connected to the first power feed line 25a in parallel. In a similar manner, nine series circuits each having six light-emitting elements 3b connected in series are connected to the second power feed line 25b in parallel. These first power feed line 25a and second power feed line 25b form independent electric power feed lines individually, and therefore the first power feed line 25a and the second power feed line 25b can be selectively switched therebetween by a change-over switch etc. (not illustrated) provided on a power circuit.

Individual light-emitting elements rows are electrically provided in parallel to the first power feed line 25a or the second power feed line 25b and are supplied with power through the first power feed line 25a or the second power feed line 25b. Therefore, even if any one of the light-emitting elements rows can not emit light due to a bonding failure or the like, the light-emitting device 1 as a whole does not stop emitting light.

With this arrangement, it is possible to provide a light-emitting device and a lighting apparatus that can change the luminance color and is good in the uniformity of illumination light as a whole.

### (Fourth Embodiment)

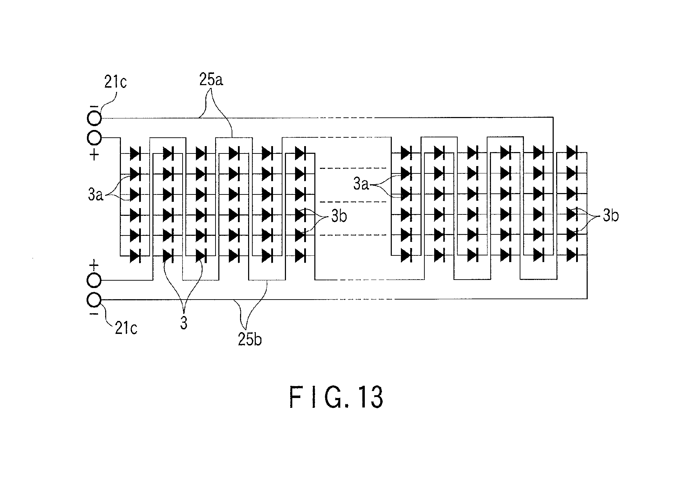

Next, a fourth embodiment will be described with reference to FIG. 13. Here, a configuration having a function identical with or similar to those of the first and second embodiments is given the same reference numeral, and an explanation thereof will be omitted. In addition, configurations other than those described below are the same as those of the second embodiment.

FIG. 13 reflects an actual layout state of a first power feed line 25a, a second power feed line 25b, and individual light-emitting elements 3 on the substrate 2. Here, a portion identical with that of the first embodiment is given the same reference numeral, and an explanation thereof will be omitted.

Nine parallel circuits each having six light-emitting elements 3a connected in parallel are connected to the first power feed line 25a in series. In a similar manner, nine parallel circuits each having six light-emitting elements 3b connected in parallel are connected to the second power feed line 25b in series.

These first power feed line 25a and second power feed line 25b form independent electric power feed lines individually, and therefore the first power feed line 25a and the second power feed line 25b can be selectively switched therebetween by a change-over switch etc. provided on a power circuit.

According to such a configuration, in addition to the effect provided in the first embodiment, currents flowing through individual parallel circuits become equal to each other, and thereby variations in light outputs or emitted colors of the individual parallel circuits are reduced, and the uniformity of the illumination light as a whole can be improved.

### (Fifth Embodiment)

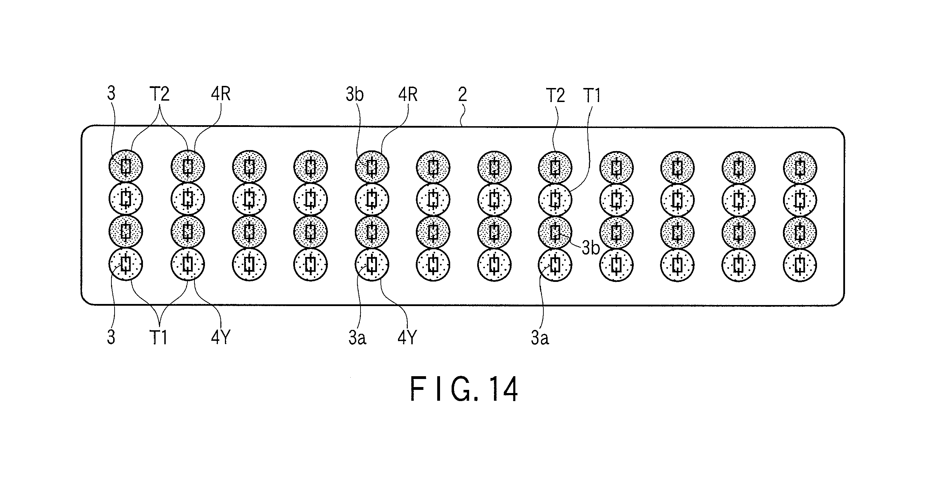

Next, a fifth embodiment will be described with reference to FIG. 14. Here, a configuration having a function identical with or similar to those of the first and second embodiments is given the same reference numeral, and an explanation thereof will be omitted. In addition, configurations other than those described below are the same as those of the second embodiment.

In this embodiment, the first light sources T1 and the second light sources T2 are arranged alternately in a distributed manner in a longer direction of a substrate. Here, a phosphor layer 4 has a mound-like shape and covers light-emitting elements 3 individually.

Also, with this configuration, it is possible to switch between the first light sources T1 and the second light sources T2 to change a luminance color and make the uniformity of illumination light good as a whole. Here, a lighting apparatus 11 may be provided with the light-emitting device 1 according to any one of the foregoing third to fifth embodiments.

The embodiments are not limited to the specific configurations of each embodiment described above. Accordingly, various modifications may be made without departing from the spirit or scope of the invention. For example, the light-emitting element is a solid-state light-emitting element such as an LED. Further, the number of the light-emitting elements to be mounted is not particularly limited.

Although it is preferable that the layout pattern of the plurality of light-emitting elements be such a form in which the plurality of light-emitting elements are arranged in a direction perpendicular to the longer direction of the substrate to form a plurality of rows, the embodiment is not particularly limited to this layout pattern.

In addition, when emitting color of light bulb color is obtained as the second light source, for example, it is also possible to make such an arrangement in which light-emitting elements emitting blue color and light-emitting elements emitting red color are alternately arranged, and a phosphor layer containing a yellow phosphor covers thereon. With this arrangement, it is possible to emit light of light bulb color that compensates for the lack of a red component.

Further, the light source is not restricted to two types. To be specific, without limiting to selective switching between the daylight color and the light bulb color, neutral white color, white color, and warm white color are added thereto and are configured in such a way to change the color among these. Furthermore, although white based color is desirable as the light emitting color, the embodiment is not limited to this. For example, it is also possible to selectively change between daylight color and blue color.

In a case in which a plurality of groups (plurality of light sources) having different color temperatures are mixed as in the second to fifth embodiments, individual color temperature rows (individual color temperature groups) may be arbitrarily controlled. For example, one of the color temperature groups may be controlled when the light is turned on. In a case where two color temperature groups are lit on, both of them may be controlled or respectively controlled so that light intensity control or color temperature control may be performed.

The lighting apparatus can be applied to a lighting apparatus for indoor or outdoor use, or to a display apparatus or the like.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light-emitting device (1) **characterized by** comprising:
a series circuit (K) including a plurality of parallel circuits (J) each including a plurality of first light-emitting elements (3, 3a) connected in parallel, the plurality of parallel circuits (J) being connected in series;
a substrate (2) on which a plurality of groups are provided, each of the groups including at least one of the first light-emitting elements (3, 3a) in the parallel circuit (J), the first light-emitting elements (3, 3a) being arranged in a divided manner according to each of the groups; and
a first sealing member (4, 4Y) that covers at least one of the first light-emitting elements (3, 3a).

2. The light-emitting device according to claim 1,
**characterized in that** the substrate (2) has substantially a rectangular shape,
the first light-emitting elements (3, 3a) are arranged on the substrate (2) plurally in a direction perpendicular to a longer direction of the substrate (2), and
the groups of the first light-emitting elements (3, 3a) are arranged in a divided manner by forming a plurality of rows.

3. The light-emitting device according to claim 1 or 2,
**characterized in that** the series circuit (K) includes a first power feed line (25a),
the substrate (2) includes a second power feed line (25b),
the light-emitting device (1) comprises:
first light sources (T1) each including the first light-emitting elements (3a) connected to the first power feed line (25a) and the first sealing member (4Y), and configured to emit light having a predetermined correlated color temperature, and includes; and
second light sources (T2) each including a plurality of second light-emitting elements (3b) connected to the second power feed line (25b) and mounted on the substrate (2) and a second sealing member (4R) that seals at least one of the second light-emitting elements (3b), and configured to emit light having a correlated color temperature different from that of the first light source (T1), and
the first light sources (T1) and the second light sources (T2) are arranged on the substrate (2) in a distributed manner.

4. The light-emitting device according to claim 3,
**characterized in that** the correlated color temperature of the first light source (T1) is set at 7000 K to 4500 K, and
the correlated color temperature of the second light source (T2) is set at 3500 K to 2500 K.

5. The light-emitting device according to claim 3,
**characterized in that** the first light sources (T1) and the second light sources (T2) are provided in a manner to form a plurality of rows arranged in a longer direction of the substrate (2).

6. A lighting apparatus **characterized by** comprising:
a apparatus body (11a); and
the light-emitting device (1) according to any one of claims 1 to 5 which is attached to the apparatus body (11a).
